# EUROPÄISCHE PATENTSCHRIFT

(11) **EP 2 346 162 B1**
(45) Veröffentlichungstag und Bekanntmachung des Hinweises auf die Patenterteilung: **05.06.2013**
(21) Anmeldenummer: 11001969.2
(22) Anmeldetag: 14.03.2009
(51) Int. Cl.: H03F 1/30, H03F 3/189

(54) **Vorrichtung zur Kompensation von Verstärkungsänderungen bei einer Verstärkerschaltung**
Method and device for compensating amplification variations in an amplifier circuit
Procédé et dispositif pour compenser des variations d'amplification dans un circuit amplificateur

(30) Priorität: 28.03.2008 DE 102008016154
(43) Veröffentlichungstag der Anmeldung: 20.07.2011
(62) Teilanmeldung aus: 09724485.9
(73) Patentinhaber: EADS Deutschland GmbH, 85521 Ottobrunn (DE)
(72) Erfinder: Schroth, Jörg, 89073 Ulm (DE); Reber, Rolf, 89077 Ulm (DE); Rittmeyer, Rainer, 89081 Ulm (DE); Sledzik, Hardy, 89134 Blaustein (DE)
(74) Vertreter: Riegel, Werner

(56) Entgegenhaltungen:
- EP-A- 1 686 687
- US-A1- 2002 158 688
- US-B1- 6 836 184

## Beschreibung

Die Erfindung betrifft eine Vorrichtung zur Kompensation von Verstärkungsänderungen bei einer Verstärkerschaltung.

Schaltungen zur Verarbeitung von HF-Signalen, z.B. in Sende-/Empfangsmodulen für phasengesteuerte Antennen, umfassen üblicherweise GaAs Hochfrequenzbausteine in Form von monolithisch integrierten Mikrowellenschaltungen (MMIC). Die Bauelementeeigenschaften solcher HF-Bauteile sind in der Regel temperaturabhängig, d.h. die elektrischen Eigenschaften der HF-Bauteile variieren in Abhängigkeit der Temperatur. Diese Temperaturabhängigkeit der HF-Bauteile beeinflusst nachhaltig die elektrischen Eigenschaften der Module und Schaltungen, in denen die HF-Bauteile eingebaut sind. GaAs Hochfrequenzbausteine weisen zudem eine Streuung ihrer optimalen Kontrollspannung (z.B. Gate-Spannung) auf und zwar von Wafer zu Wafer und von Los zu Los. Die Anforderungen können von ca -1.0Volt bis 0Volt variieren. Die Bauteile eines Wafers können mit identischer Gate-Spannung betrieben werden wobei jedoch eine Streuung der HF-Eigenschaften von Bauelement zu Bauelement bleibt.

Eine manuelle individuelle Einstellung der Schaltungen oder Module ist zeit- und kostenintensiv und bei hoher Produktionsrate nicht sinnvoll. Es ist daher wünschenswert, das Modul oder die Schaltung so auszulegen, daß Bauteilestreuungen automatisch korrigiert werden (Spreadkompensation) und Temperatureffekte über eine einfache, temperaturabhängige Steuerung weitgehend ausgeglichen werden (Temperaturkompensation).

Aus US 2007/243846 A1 ist ein Verfahren zur Kompensation von Verstärkungsänderungen bei einer Verstärkerschaltung umfassend HF-Bauteilen und Dämpfungsgliedem. Aus US 6,836,184 B1 ist eine Vorrichtung entsprechend des Oberbegriffs des Anspruchs 1 bekannt.

Aus EP 1 293 798 B1 ist eine Schaltung für ein Sende/Empfangs-Modul bekannt, mit der eine stabile und von äußeren Einflüssen nahezu unabhängige Regelung der Ausgangsleistung möglich ist. Dabei wird eine Steuerung der Ausgangsleistung des Sende/Empfangsmoduls durch gezielte Einstellung der Eingangsleistung der Sendekette erreicht, wobei der Gewinn der in der Sendekette vorhandenen Verstärker zur Verstärkung des HF-Sendesignals stets durch eine Regelung konstant gehalten wird. Bei konstantem Gewinn der Verstärker ist die Ausgangsleistung bekannt, wenn die Eingangsleistung mit einem Verstärker mit variabler Verstärkung des Sende/Empfangs-Moduls eingestellt wird.

Aufgabe der Erfindung ist es, eine Vorrichtung zur Kompensation von Verstärkungsänderungen bei Verstärkerschaltungen anzugeben.

Diese Aufgaben werden mit der Vorrichtung gemäß Anspruch 1 gelöst. Vorteilhafte Ausführungen der Erfindung sind Gegenstand von Unteransprüchen.

Die erfindungsgemäße Vorrichtung umfasst Speichereinrichtungen zur permanenten Speicherung von Werten zur Erzeugung von Kontrollspannungen für die Hochfrequenzbausteine und Dämpfungsglieder und elektrische Schaltungen mit einem Eingang und einem Ausgang zur Erzeugung einer temperaturabhängigen Ausgangsspannung unter Berücksichtigung einer an den elektrischen Schaltungen anliegenden temperaturabhängigen Eingangsspannung U_{IST}(T) und eines in den Speichereinrichtungen gespeicherten Wertes, wobei jedem Hochfrequenzbaustein und jedem Dämpfungsglied eine Speichereinrichtung zugeordnet ist. Gemäß der Erfindung ist der gespeicherte Wert in der Speichereinrichtung dauerhaft gespeichert und entspricht einer einem Hochfrequenzbaustein zugeordneten individuellen Kontrollspannung Uₒₚₜ zur Einstellung des optimalen Arbeitspunktes für diesen Hochfrequenzbaustein, wobei die individuelle Kontrollspannung Uₒₚₜ für einen Hochfrequenzbaustein herstellungsbedingt ist. Ein weiterer Aspekt der Erfindung ist, dass die Vorrichtung einen Ausgangsleistungsverstärker sowie ein Widerstandnetzwerk zur Erzeugung einer gepulsten temperaturabhängigen Steuerspannung U_{LV}(T) für den Ausgangsleistungsverstärker umfasst.

Im Folgenden wird unter einem Dämpfungsglied grundsätzlich ein Verstärker mit variabler Verstärkung und unter einem Hochfrequenzbaustein eine monolithisch integrierten Mikrowellenschaltungen (MMIC) verstanden.

Die erste temperaturabhängige Kontrollspannung U_{HF}(T) basiert auf einer vom Hersteller des Hochfrequenzbauteils angegebenen Spannung. Diese Spannung ist individuell für den jeweils hergestellten Wafer und gibt die individuelle Kontrollspannung Uₒₚₜ zur Einstellung des optimalen Arbeitspunktes für einen Hochfrequenzbaustein dieses Wafers an.

Ein Datenwort, das dieser als individuelle Kontrollspannung Uₒₚₜ bezeichneten Spannung entspricht, wird zweckmäßig in eine erste dem Hochfrequenzbaustein zugeordnete Speichereinrichtung eingelesen. Das Einlesen und Speichern dieses Datenwortes erfolgt zweckmäßig einmalig und dauerhaft bei erstmaliger Durchführung des Verfahrens.

Die Streuung der Eigenschaften der Hochfrequenzbauteile wird durch eine HF-Messung ermittelt und mittels eines spannungsgesteuerten Dämpfungsglieds kompensiert, indem die Spannung U_{VG_T} am Dämpfungsglied in einem Iterationsverfahren variiert wird und somit die Verstärkung so eingestellt wird, bis zwischen Ein- und Ausgang der Verstärkerschaltung die gewünschte Verstärkung erzielt wird. Diese Messung wird zweckmäßig bei einer festen Temperatur z.B. 25°C durchgeführt. Das Datenwort, das dieser ermittelten Kontrollspannung U_{VG}__{T} entspricht, wird zweckmäßig in eine zweite, dem Dämpfungsglied zugeordneten Speichereinrichtung eingelesen. Das Einlesen und Speichern des Wertes in der zweiten Speichereinrichtung erfolgt einmalig und dauerhaft bei erstmaliger Durchführung des Verfahrens.

Die Verstärkerschaltung kann eine Kette von Hochfrequenzbausteinen und/oder Dämpfungsglieder enthalten. In diesem Fall wird für jeden Hochfrequenzbaustein das Datenwort für die individuellen Kontrollspannung Uₒₚₜ und für jedes Dämpfungsglied das Datenwort der ermittelten Kontrollspannung U_{VG}__{T} gespeichert. Die Speicherung erfolgt dabei in Speichereinrichtungen, wobei jedem Hochfrequenzbaustein und jedem Dämpfungsglied vorteilhaft jeweils eine Speichereinrichtung zugeordnet ist.

Für jeden HF-Baustein und für jedes Dämpfungsglied sind jeweils eine elektrische Schaltung mit einem Eingang und einem Ausgang vorgesehen. Am Eingang dieser elektrischen Schaltung liegt ein temperaturabhängiges Eingangssignal U_{IST}(T) an.

Das Eingangssignal U_{IST}(T) wird zweckmäßig mittels einer Diode als Temperatursensor und einem der Diode nach geschalteten Operationsverstärker erzeugt. Die elektrische Schaltung erzeugt am Ausgang eine temperaturabhängige Kontrollspannung, wobei einer Spannung eine Temperaturabhängigkeit in Abhängigkeit des Eingangssignals U_{IST}(T) aufgeprägt wird. Diese Spannung entspricht dabei jeweils dem für ein HF-Bauteil oder Dämpfungsglied gespeicherten Wertes. Diese Temperaturabhängigkeit kann z.B. einen linearen, quadratischen, exponentiellen oder polynomischen Verlauf aufweisen.

Aufgrund der Temperaturabhängigkeit der Kontrollspannung U_{HF}(T) werden temperaturbedingte Änderungen in den Eigenschaften der Hochfrequenzbausteine kompensiert.

Hochfrequenzbauteile können z.B. HF-Verstärkerstufen sein, welche mit einer Gate-oder Basisspannung angesteuert werden. Physikalisch bedingt ändert sich die Verstärkung einer Verstärkerstufe um ca. 0.01 dB/K. Dies bedeutet bei z.B. 5 Stufen und 100K Temperaturänderung eine Verstärkungsänderung von ca. 5dB (linear: Faktor 3). Gewünscht ist etwa 1/10 diese Wertes oder weniger. Gelöst wird dieses Problem durch eine temperaturabhängige Dämpfung des spannungsgesteuerten Dämpfungsgliedes, gerade so, dass die temperaturbedingte Verstärkungsänderung der Hochfrequenzbauteile kompensiert wird.

In einer weiteren vorteilhaften Ausgestaltung der Erfindung sind die Speichereinrichtungen und elektrischen Schaltungen in einem digitalen Potentiometer integriert. Das digitale Potentiometer weist einen Eingang auf und für jeden Hochfrequenzbaustein und jedes Dämpfungsglied einen Ausgang. Am Eingang liegt die temperaturabhängige Eingangsspannung U_{IST}(T) an und am Ausgang liegt die für das mit dem jeweiligen Ausgang verbundene Hochfrequenzbauteil oder Dämpfungsglied entsprechende Kontrollspannung an. Zweckmäßig werden in der Speichereinrichtung des digitalen Potentiometers die Werte der Spannungsteiler (Teilerverhältnis), die zur Kontrollspannungen Uₒₚₜ für die Hochfrequenzbauteile und zur Kontrollspannungen U_{VG_T} für die Dämpfungsglieder führen, digital gespeichert.

Die Erfindung sowie vorteilhafte Ausführungen werden von Figuren näher erläutert. Es zeigen:
- Fig. 1: eine erfindungsgemäße Vorrichtung für einen Empfangspfad eines Sende- /Empfangsmoduls
- Fig. 2: eine erfindungsgemäße Vorrichtung für einen Sendepfad eines Sende- /Empfangsmoduls

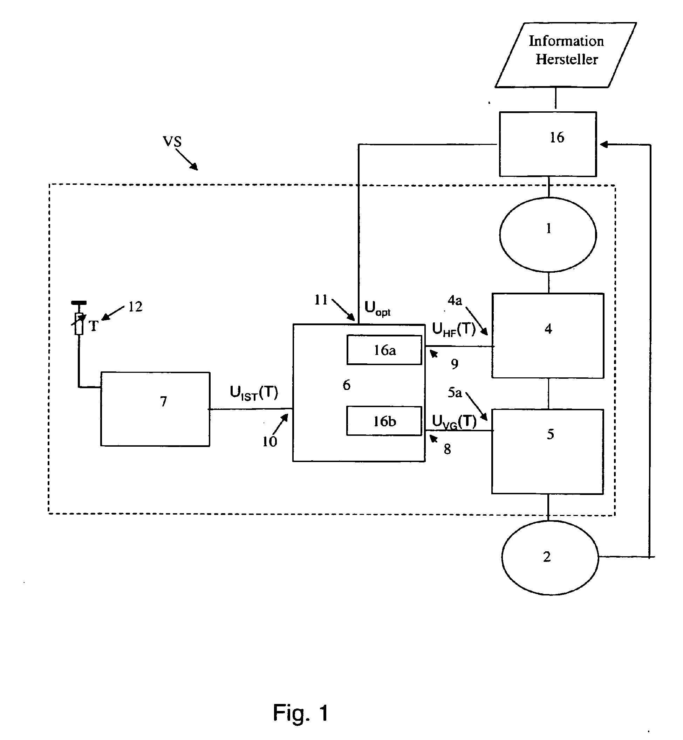

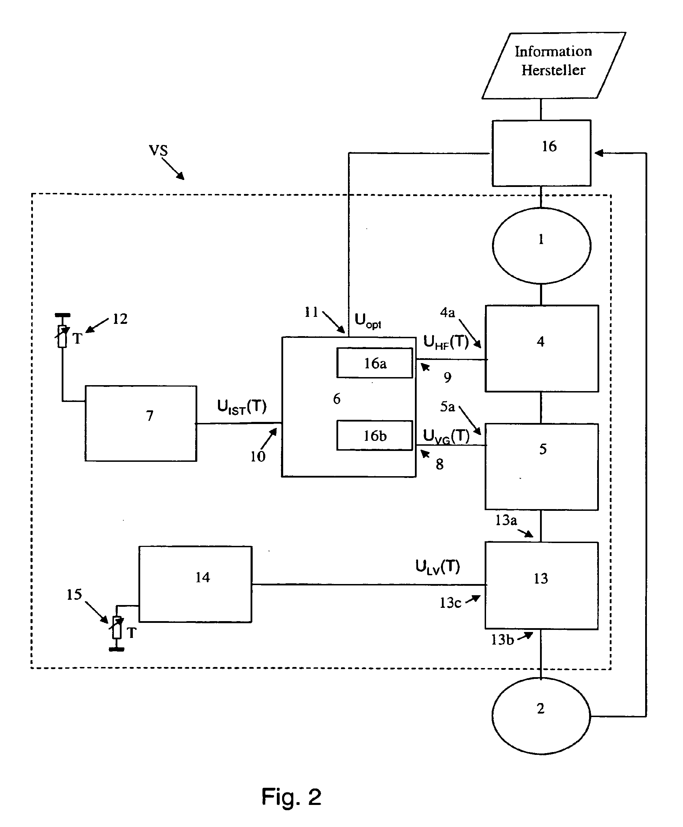

In den Fig. 1 und 2 wird die Erfindung anhand des Sende- und Empfangspfades eines Sende-/Empfangsmoduls näher erläutert.

Die Fig. 1 und 2 zeigen jeweils eine Verstärkerschaltung VS mit einem Eingang 1 und einem Ausgang 2. Der Eingang 1 ist mit einem Hochfrequenzbauteil 4 verbunden. Dieses Hochfrequenzbauteil 4 ist üblicherweise eine Verstärkerstufe. Das Hochfrequenzbauteil 4 ist über ein Dämpfungsglied 5 mit dem Ausgang 2 verbunden. Das HF-Bauteil 4 weist einen Eingang 4a auf, welchem eine temperaturabhängige Kontrollspannung U_{HF}(T) zugeführt ist. Das variable Dämpfungsglied 5 weist einen Eingang 5a auf, welchem eine temperaturabhängige Kontrollspannung U_{VG}(T) zugeführt ist.

Die Verstärkerschaltung VS weist ein digitales Potentiometer 6 mit zweckmäßig integrierten Datenspeichern 16a, 16b auf. Das digitale Potentiometer 6 besitzt einen Eingang 10, an welchem eine temperaturabhängige Eingangsspannung U_{IST}(T) anliegt. Über einen weiteren Eingang 11 können Werte in das digitale Potentiometer 6 eingelesen und in den Datenspeichern 16a, 16b abgespeichert werden.

Die Verstärkerschaltung VS weist zweckmäßig eine Diode 12 als Temperatursensor und einen Steuerverstärker 7, z.B. einen Operationsverstärker, zur Verstärkung der Diodenspannung auf. Mit dieser Anordnung wird am Ausgang des Steuerverstärkers 7 die temperaturabhängige Spannung U_{IST}(T) erzeugt, welche dem Eingang 10 des digitalen Potentiometers 6 zugeführt ist.

Am digitalen Potentiometer 6 sind eine Anzahl von Ausgängen 8, 9 vorhanden, wobei jedes HF-Bauteil 4 und jedes Dämpfungsglied 5 mit genau einem Ausgang 8, 9 verbunden ist. Der Ausgang 8 des Potentiometers 6 ist mit dem Eingang 5a des Dämpfungsgliedes und der Ausgang 9 des Potentiometers 6 ist mit dem Eingang 4a des HF-Bauteils 4 verbunden.

Fig. 2 zeigt in einer besonderen Ausführungsform der Erfindung den Sendepfad eines Sende-/Empfangsmoduls. Die in Fig. 1 dargestellte Verstärkerschaltung VS ist hierbei um einen am Ausgang 2 (Fig. 1) angeschlossenen Leistungsverstärker 13 erweitert. Der Ausgang 2 der Verstärkerschaltung VS ist somit mit dem Ausgang 13 b des Leistungsverstärkers 13 verbunden. Dieser Leistungsverstärker 13 verstärkt am Ausgang 13b ein am Eingang 13a anliegendes Sendesignal. Über einen weiteren Eingang 13c ist dem Leistungsverstärker 13 eine gepulste temperaturabhängige Steuerspannung U_{LV}(T) zugeführt.

Die Verstärkerschaltung VS umfasst ferner ein Widerstandnetzwerk 14 zur Erzeugung einer temperaturabhängige Steuerspannung U_{LV}(T) für den Ausgangsleistungsverstärker 13. Das Widerstandsnetzwerk 14 umfasst zweckmäßig Widerstände mit negativem Temperaturkoeffizient 15 und eine Zenerdiode.

Zweckmäßig besteht der Ausgangsleistungsverstärker 13 aus einem Leistungsverstärker mit vorgeschaltetem Treiberverstärker (nicht dargestellt). Durch die temperaturabhängige Spannung U_{LV}(T) des Widerstandsnetzwerks wird einerseits die Verstärkung des dem Leistungsverstärker 13 vorgeschalteten Treiberverstärkers (nicht dargestellt) und andererseits die Verstärkung des Leistungsverstärkers 13 selbst beeinflusst. Dazu wird die Kontrollspannung des Treiberverstärkers und des Leistungsverstärkers 13 über der Temperatur so verändert, dass bei höchster Betriebstemperatur die höchste Kontrollspannung anliegt, welche mit abnehmender Temperatur ebenfalls abnimmt. Die Temperaturabhängigkeit wird im Widerstandsnetzwerk 14 über NTCs (Widerstände mit negativem Temperaturkoeffizienten) und Widerstände gesteuert. Dadurch wird der natürlichen Zunahme der Verstärkung bei abnehmenden

Temperaturen entgegengewirkt, wodurch die Ausgangsleistung am Ausgang 2 über einen weiten Temperaturbereich konstant gehalten werden kann.

Im Weiteren wird erläutert, wie die Kontrollspannung U_{VG}__{T} für das Dämpfungsglied ermittelt wird.

Der ermittelte Wert der Kontrollspannung U_{VG}__{T} korrespondiert zu einem vorgebbaren Verhältnis der Ausgangsleistung am Ausgang des Dämpfungsglied 5 zur Eingangsleistung am Eingang 1 der Verstärkerschaltung VS.

Dieser Wert wird bei Inbetriebnahme der Schaltung mittels einer Testeranordnung 16 ermittelt. Die Inbetriebnahme der Schaltung wird zweckmäßig bei einer konstanten Temperatur z.B. 25°C durchgeführt.

Hierbei wird in einem ersten Schritt dem Eingang 11 des digitalen Potentiometers 6 ein digitales Wort (Teilerverhältnis) zugeführt, welches einer dem jeweils verwendeten und vom Potentiometer 6 angesteuerte HF-Bauteil 4 individuellen Spannung Uₒₚₜ entspricht. Diese individuelle Spannung Uₒₚₜ, welche zwischen ca -1.0 bis 0V liegt, ist für das HF-Bauteil herstellungsbedingt gegeben und einem Fachmann bekannt. Das Teilerverhältnis für die Spannung Uₒₚₜ wird in einem im Potentiometer 6 integriertem Speicherbaustein 16a gespeichert. Selbstverständlich kann der Speicherbaustein 16a auch getrennt vom Potentiometer 6 angeordnet sein mit einer elektrischen Verbindung zum Potentiometer 6.

Das digitale Potentiometer 6 erzeugt auf Grund des gespeicherten Teilerverhältnisses und der temperaturabhängigen Spannung U_{IST}(T) am Eingang 10 eine analoge temperaturabhängige Spannung U_{HF}(T) am Ausgang 9, welche als Kontrollspannung dem HF-Bauteil zugeführt wird.

Anschließend werden mittels der Testeranordnung 16 dem Eingang 1 der Verstärkerschaltung VS Testsignale zugeführt und mittels Variation des dem Ausgang 8 zugeordneten Teilerverhältnisses die Kontrollspannung U_{VG_T} am Dämpfungsglied 5 und somit dessen Dämpfung, variiert, bis die gewünschte Verstärkung der Verstärkerschaltung am Ausgang des Dämpfungsglieds 5 erreicht ist. Das resultierende Teilerverhältnis wird in dem zweckmäßig nicht-flüchtigen Speicher 16b im Digitalen Potentiometer 6 gespeichert. Selbstverständlich kann der Speicherbaustein 16b auch getrennt vom Potentiometer 6 angeordnet sein mit einer elektrischen Verbindung zum Potentiometer 6.

Die Kompensation der unvermeidlichen Parameterstreuung und der Temperaturabhängigkeit der HF-Bauteile kann entweder durch manuelle Einstellung oder aufwändige Regelung geschehen. In einem einmaligen Schritt werden eine Spannung Uₒₚₜ für das HF-Bauteil und eine Spannung U_{VG}__{T} für das Dämpfungsglied festgelegt, welche dann entsprechend der Temperatur automatisch variiert werden können. Hieraus ergeben sich die Vorteile, dass die HF-Bauteile nicht sehr eng toleriert spezifiziert werden müssen, wodurch sich die Ausbeute beim Hersteller (GaAs Foundry) erhöht. Gleichzeitig können damit die Preise der HF-Bauteile reduziert werden. Ferner kann die Streuung der Verstärkerschaltung VS um einen Faktor von ca. 10 reduziert werden. Dadurch erhöht sich die Fertigungsausbeute der Verstärkerschaltung VS.

Zweckmäßig sind die Speichereinrichtung, elektrische Steuerschaltung und das digitale Potentiometer in einer anwenderspezifisch integrierten Schaltung, einem so genannten ASIC integriert.

## Patentansprüche

1. Vorrichtung zur Kompensation von Verstärkungsänderungen bei einer Verstärkerschaltung umfassend Hochfrequenzbausteine (4) und Dämpfungsglieder (5), wobei
Speichereinrichtungen (16a, 16b) zur permanenten Speicherung von Werten zur Erzeugung von Kontrollspannungen für die Hochfrequenzbausteine (4) und Dämpfungsglieder (5) und
elektrische Schaltungen (6) mit einem Eingang (10, 11) und einem Ausgang (8, 9) zur Erzeugung einer temperaturabhängigen Ausgangsspannung unter Berücksichtigung einer an den elektrischen Schaltungen (6) anliegenden temperaturabhängigen Eingangsspannung U_{IST}(T) und einem in den Speichereinrichtungen (16a, 16b) gespeicherten Wertes
vorhanden sind und wobei
jedem Hochfrequenzbaustein (4) und jedem Dämpfungsglied (5) eine Speichereinrichtung (16a, 16b) zugeordnet ist,
**dadurch gekennzeichnet, dass**
der gespeicherte Wert in den Speichereinrichtungen (16a, 16b) dauerhaft gespeichert ist und einer einem Hochfrequenzbaustein (4) zugeordneten individuellen Kontrollspannung Uₒₚₜ zur Einstellung des optimalen Arbeitspunktes für diesen Hochfrequenzbaustein (4) entspricht, wobei die individuelle Kontrollspannung Uₒₚₜ für einen Hochfrequenzbaustein (4) herstellungsbedingt ist,
die Vorrichtung einen Ausgangsleistungsverstärker (13) sowie ein Widerstandnetzwerk (14) zur Erzeugung einer gepulsten temperaturabhängigen Steuerspannung U_{LV}(T) für den Ausgangsleistungsverstärker umfasst.

2. Vorrichtung nach Anspruch 1,
**dadurch gekennzeichnet, dass**
eine elektrische Steuerschaltung (7) vorhanden ist umfassend einen Temperatursensor (12), z.B. Diode, Transistor oder integrierte Schaltung (IC) und einem dem Temperatursensor (12) nach geschalteten Operationsverstärker zur Erzeugung der temperaturabhängigen Spannung U_{IST}(T).

3. Vorrichtung nach Anspruch 2,
**dadurch gekennzeichnet, dass**
das Widerstandsnetzwerk (14) Widerstände mit negativem Temperaturkoeffizienten umfasst.

4. Vorrichtung nach einem der Ansprüche 1 bis 3,
**dadurch gekennzeichnet, dass**
die Speichereinrichtungen (16a, 16b) und elektrischen Schaltungen (6) in einem digitalen Potentiometer integriert sind mit einem Eingang (10) zur Zuführung eines temperaturabhängigen Eingangssignals U_{IST}(T) sowie Ausgängen (8, 9), welche jeweils einem Hochfrequenzbaustein (4) und einem Dämpfungsglied (5) zugeordnet sind.

5. Vorrichtung nach Anspruch 4,
**dadurch gekennzeichnet, dass**
die Speichereinrichtungen (16a, 16b), elektrische Steuerschaltungen (6) und das digitale Potentiometer (6) in einer anwenderspezifisch integrierten Schaltung integriert sind.

## Claims

1. Apparatus for compensating for gain changes in an amplifier circuit comprising radio-frequency modules (4) and attenuation elements (5),
storage devices (16a, 16b) for permanently storing values for producing monitoring voltages for the radio-frequency modules (4) and attenuation elements (5) and
electrical circuits (6) having an input (10, 11) and an output (8, 9) for producing a temperature-dependent output voltage taking into account a temperature-dependent input voltage U_{IST}(T) applied to the electrical circuits (6) and a value stored in the storage devices (16a, 16b)
being provided, and
a storage device (16a, 16b) being associated with each radio-frequency module (4) and each attenuation element (5),
**characterized in that**
the stored value is permanently stored in the storage devices (16a, 16b) and corresponds to an individual monitoring voltage Uₒₚₜ which is associated with a radio-frequency module (4) and is intended to set the optimum operating point for this radio-frequency module (4), the individual monitoring voltage Uₒₚₜ for a radio-frequency module (4) being governed by production, and
the apparatus comprises an output power amplifier (13) and a resistance network (14) for producing a pulsed temperature-dependent control voltage U_{LV}(T) for the output power amplifier.

2. Apparatus according to Claim 1,
**characterized in that**
an electrical control circuit (7) is provided, comprising a temperature sensor (12), for example a diode, a transistor or an integrated circuit (IC), and an operational amplifier, which is downstream of the temperature sensor (12), for producing the temperature-dependent voltage U_{IST}(T).

3. Apparatus according to Claim 2,
**characterized in that**
the resistance network (14) comprises resistors with a negative temperature coefficient.

4. Apparatus according to one of Claims 1 to 3,
**characterized in that**
the storage devices (16a, 16b) and electrical circuits (6) are integrated in a digital potentiometer having an input (10) for supplying a temperature-dependent input signal U_{IST}(T) and outputs (8, 9) which are each associated with a radio-frequency module (4) and an attenuation element (5).

5. Apparatus according to Claim 4,
**characterized in that**
the storage devices (16a, 16b), electrical control circuits (6) and the digital potentiometer (6) are integrated in an application-specific integrated circuit.

## Revendications

1. Dispositif pour la compensation de variations de gain dans un circuit amplificateur comprenant des composants à haute fréquence (4) et des éléments d'amortissement (5), dans lequel
il est prévu des dispositifs à mémoire (16a, 16b) pour le stockage permanent de valeurs afin de générer des tensions de commande destinées aux composants à haute fréquence (4) et aux éléments d'amortissement (5), et des circuits électriques (6) comportant une entrée (10, 11) et une sortie (8, 9) pour générer une tension de sortie dépendant de la température compte tenu d'une tension d'entrée U_{IST}(T) dépendant de la température appliquée aux circuits électriques (6) et d'une valeur stockée dans les dispositifs à mémoire (16a, 16b) et dans lequel
un dispositif à mémoire (16a, 16b) est associé à chaque composant à haute fréquence (4) et à chaque élément d'amortissement (5),
**caractérisé en ce que**
la valeur stockée est stockée de manière permanente dans les dispositifs à mémoire (16a, 16b) et correspond à une tension de commande individuelle Uₒₚₜ associée à un composant à haute fréquence (4) pour le réglage du point de fonctionnement optimal pour ce composant à haute fréquence (4), dans lequel la tension de commande individuelle Uₒₚₜ est liée à la fabrication d'un composant à haute fréquence (4), le dispositif comprend un amplificateur de puissance de sortie (13) ainsi qu'un réseau de résistances (14) pour générer une tension de commande impulsionnelle U_{LV}(T) dépendant de la température pour l'amplificateur de puissance de sortie.

2. Dispositif selon la revendication 1, **caractérisé en ce qu'**il est prévu un circuit de commande électrique (7) comprenant un capteur de température (12), par exemple une diode, un transistor ou un circuit intégré (IC) et un amplificateur opérationnel connecté en aval du capteur de température (12) pour générer la tension dépendant de la température U_{IST} (T) .

3. Dispositif selon la revendication 2, **caractérisé en ce que** le réseau de résistances (14) comprend des résistances ayant des coefficients de température négatifs.

4. Dispositif selon l'une quelconque des revendications 1 à 3, **caractérisé en ce que** les dispositifs à mémoire (16a, 16b) sont des circuits électriques (6) intégrés à un potentiomètre numérique, avec une entrée (10) permettant la fourniture d'un signal d'entrée dépendant de la température U_{IST}(T), et avec des sorties (8, 9) qui sont respectivement associées à un composant à haute fréquence (4) et à un élément d'amortissement (5).

5. Dispositif selon la revendication 4, **caractérisé en ce que** les dispositifs à mémoire (16a, 16b), les circuits de commande électriques (6) et le potentiomètre numérique (6) sont intégrés à un circuit intégré personnalisé.
